# EUROPÄISCHE PATENTSCHRIFT

(11) **EP 3 382 412 B1**
(45) Veröffentlichungstag und Bekanntmachung des Hinweises auf die Patenterteilung: **29.07.2020**
(21) Anmeldenummer: 18163401.5
(22) Anmeldetag: 22.03.2018
(51) Int. Cl.: G01R 33/383, G01R 33/3873, H01F 7/02

(54) **PERMANENTMAGNETANORDNUNG FÜR MR-APPARATUREN MIT AXIAL UND LATERAL VERSCHIEBBAREN, DREHBAR GELAGERTEN RINGBAUGRUPPEN**
PERMANENT MAGNET ASSEMBLY FOR MR DEVICES WITH AXIALLY AND LATERALLY MOVABLE ROTATABLY MOUNTED RING ASSEMBLIES
ENSEMBLE D'AIMANTS PERMANENTS POUR APPAREILS RM POURVUS D'ENSEMBLES D'ANNEAUX LATÉRAUX MONTÉS COULISSANTS, ROTATIFS

(30) Priorität: 31.03.2017 DE 102017205485
(43) Veröffentlichungstag der Anmeldung: 03.10.2018
(73) Patentinhaber: Bruker BioSpin GmbH, 76287 Rheinstetten (DE)
(72) Erfinder: Niemann, Volker, 75228 Ispringen (DE); Pietig, Rainer, 76316 Malsch (DE); Hänichen, Lukas, 76137 Karlsruhe (DE)
(74) Vertreter: Kohler Schmid Möbus Patentanwälte

(56) Entgegenhaltungen:
- EP-A1- 0 479 278
- EP-A1- 2 144 076
- US-A- 4 931 760
- US-A- 5 014 032
- Hung Dang Phuc ET AL: "DESIGN AND CONSTRUCTION OF LIGHT WEIGHT PORTABLE NMR HALBACH MAGNET", International Journal on Smart Sensing and Intelligent Systems, 1. Dezember 2014 (2014-12-01), Seiten 1555-1578, XP055495768, DOI: 10.21307/ijssis-2017-720 Gefunden im Internet: URL:http://s2is.org/Issues/v7/n4/papers/pa per6.pdf [gefunden am 2018-07-27]

## Beschreibung

Die Erfindung betrifft eine Magnetanordnung für den Einsatz in einer Magnetresonanz-Apparatur mit einem Permanentmagnetsystem zur Erzeugung eines homogenen Magnetfeldes in Richtung senkrecht zu einer z-Achse in einem Messvolumen, wobei das Permanentmagnetsystem mindestens 2, insbesondere mindestens 3, bezüglich der z-Achse zylindersymmetrisch und in z-Richtung übereinander gestapelt und/oder konzentrisch angeordnete, ringförmige Magnetelemente aus magnetischem Material umfasst, wobei die ringförmigen Magnetelemente aus einzelnen Magnetsegmenten aufgebaut und so angeordnet sind, dass die Magnetisierungsrichtung der Einzelsegmente in den jeweiligen Ringen im Wesentlichen parallel zu einer zur z-Richtung senkrechten, zu einer zur x-y-Ebene parallelen Ebene verläuft, wobei die ringförmigen Magnetelemente jeweils eine Halbach-Magnetisierung aufweisen, die ein magnetisches Dipolfeld erzeugt, und wobei die ringförmigen Magnetelemente relativ zueinander in z-Richtung ausrichtbar sind.

Eine solche Magnetanordnung ist bekannt aus der EP 2 144 076 B1 .

### Hintergrund der Erfindung

Die vorliegende Erfindung betrifft allgemein den Bereich der Magnetresonanz, insbesondere die Bereitstellung von hierfür geeigneten Permanentmagnetsystemen, die zur Erzeugung von homogenen Magnetfeldern für NMR-Messungen bestimmt sind. Die Anwendbarkeit der Erfindung ist jedoch nicht auf dieses Gebiet beschränkt.

Sowohl im Bereich der Kernresonanzspektroskopie (NMR) als auch bei der bildgebenden Anwendung (MRI) wird in einem zu definierenden Probenvolumen ein sehr homogenes und zeitlich konstantes Magnetfeld benötigt, welches mit resistiven oder supraleitenden Spulen oder einer geeigneten Permanentmagnetanordnung erzeugt werden kann. Die Verwendung von Permanentmagneten wird bevorzugt, wenn Flussdichten von unterhalb 2T ausreichend sind und ein vergleichsweise kompakter Aufbau erwünscht ist.

Zur Maximierung des magnetischen Flusses im Probevolumen und damit gleichzeitig zur Minimierung des Streuflusses muss der magnetische Fluss gebündelt werden. Es wird dabei zwischen Magnetkreisen unterschieden, wo der magnetische Rückschluss durch ein Joch aus einem weichmagnetischem Werkstoff realisiert ist, oder solchen Magnetkreisen, die ohne Joch auskommen. Bei Letzteren handelt es sich meist um Abwandlungen sogenannter Halbach Magnete, wo der Rückfluss durch eine graduelle Änderung der Magnetisierungsrichtung vereinfacht wird. In der Praxis wird eine Halbach Anordnung typischerweise durch eine stufenweise Änderung der Magnetisierungsrichtung erzielt. Diese Abweichung von der idealen Halbach Magnetisierung und insbesondere auch die endliche Länge der Halbach Anordnung tragen zu einer Erhöhung des Streufeldes außerhalb der eigentlichen Magnetanordnung bei und machen für streufeldfreie Anwendungen eine zusätzliche Abschirmung erforderlich. Bei jochbasierten Magneten kann durch geschicktes Jochdesign und Einsatz des Jochmaterials deutlich unterhalb der Sättigungsflussdichte eine ausreichende Abschirmung des Streufeldes erzielt werden.

Um die geforderte Feldhomogenität im Probenvolumen zu erreichen, müssen bei den beschriebenen Halbach Realisierungen in der Regel Korrekturmechanismen vorgesehen werden, um Toleranzen des Magnetmaterials oder der Positionen der einzelnen Magnetblöcke ausgleichen zu können, was den mechanischen Aufbau verkompliziert.

Ein Problem besteht jetzt darin, die dominanten störenden Feldordnungen zu bestimmen und einen kausalen Zusammenhang zu einem entsprechenden Stellmechanismus herzustellen.

Naturgemäß ist es so, dass jede Änderung der räumlichen Anordnung der Magnete sich auf sämtliche Feldordnungen auswirkt. Dementsprechend artet eine Anordnung, bei der alle Magnetsegmente verstellbar sind, in ein "multidimensionales" Optimierungsproblem einer riesigen Anzahl von Freiheitsgraden aus. Das bedeutet, dass der "Ergebnisvektor" für ein bestimmtes "Shim-Ziel" sehr lang ist; man müsste quasi an sehr vielen dieser Stellelemente korrigieren. Dieser Abgleichprozess ist nicht nur zeitlich aufwändig, sondern es ist nicht von vornherein sicher, dass ein solches Vorgehen auch immer überhaupt zu einem absoluten Optimum konvergiert.

Es gibt Ordnungen, deren Korrektur höhere Priorität hat, vorwiegend die "zonalen" Terme und Lineargradienten. Es müssen also geometrische Variationen gefunden werden, die sich mit den priorisierten Ordnungen in Verbindung bringen lassen, vorzugsweise unabhängig voneinander. Diese Variationen sollten technisch möglichst simpel realisierbar sein, da man in der Regel gegen magnetische Kräfte arbeiten muss, und die Einstellpräzision bei sehr komplexen Bewegungsabläufen meist leidet bzw. ihre technische Realisierung exorbitant teuer wird. Linearbewegung und Rotation sind meist mit überschaubarem Aufwand realisierbar.

Die Permanentmagnete werden typischerweise von einer Stützstruktur gehalten, die zusätzlich die Funktion des magnetischen Rückschlusses erfüllen kann. Traditionelle Bauformen verfügen über ein Joch in Form eines rechteckigen Rahmens (Windowframe, H-Joch, C-Joch), mit zwei gegenüberstehenden zentralen Magnetbaugruppen, zwischen denen sich das Probenvolumen befindet. Auch diese Jochbauformen sind durch ihre offene Bauweise meist mit Streufeldern behaftet, die sich weit über die Außenkonturen der Magnetanordnung ausdehnen.

Um die für NMR-Messungen geforderte Feldhomogenität im Probenvolumen zu erreichen, müssen bei den jochfreien Halbach-Magneten Korrekturmechanismen vorgesehen werden, um Toleranzen des Magnetmaterials oder der Position der einzelnen Magnetblöcke ausgleichen zu können, was den mechanischen Aufbau verkompliziert. Jochbasierte Magnete besitzen in der Regel ein paralleles Polschuhpaar aus einem weichmagnetischen Werkstoff mit entsprechend hoher Sättigungsflussdichte. Durch geeignete Wahl der Polschuhgeometrie und spezielle Oberflächenbearbeitung kann das Feldprofil auf vergleichsweise einfache und effiziente Weise optimiert werden.

### Spezieller Stand der Technik

Die US 8,077,002 B2 offenbart eine Permanentmagnetvorrichtung für MRI-Anwendungen. Es geht um ein Paar massiver scheibenartiger Magnete, die den Luftspalt als Symmetrieebene parallel begrenzen und jeweils einen versetzten (vorstehenden) Ringmagneten umfassen, sodass ein L-förmiger Magnet entsteht. Polschuhe sind beiderseits des Luftspalts angeordnet zur Parallelausrichtung des Magnetfelds im Luftspalt. Die sogenannte L-Magnetanordnung wird durch ein T-Joch gehalten. Da es sich bei der vorliegenden Magnetanordnung um eine offene Struktur handelt ist dieses T-Joch konstruktionsbedingt erforderlich. Die beschriebenen T-Jochstränge sind durch einen zusätzlichen Steg als magnetischem Rückschluss verbunden.

Die US 7,084,633 B2 offenbart eine Magnetanordnung für MRT-Geräte unter Verwendung von Permanentmagneten. Die Permanentmagnete sind derart angeordnet, dass ein Paar von zentralen Permanentmagneten mit jeweils einem Polschuh verbunden sind, in deren Zwischenraum sich das Messvolumen befindet. Die Magnetisierung der beiden Magnete ist in die gleiche Richtung orientiert, sodass der Magnetfluss in eine definierte Richtung durch das Messvolumen fließt. Um die besagten Magnete herum sind weitere Segmente von Permanentmagneten kreisförmig angeordnet wobei die Magnetisierungsrichtung der Magnete radial nach außen bzw. radial nach innen gerichtet ist, sodass das Magnetfeld innerhalb den Messvolumens verstärkt wird. Als Joch, zur Rückführung des Magnetfelds sind Platten aus ferromagnetischem Material angeordnet. Aus Konstruktionsgründen und zur Führung des magnetischen Flusses der Ecksegmente sind Stützjoche an den jeweiligen Ecken erforderlich.

Die US 2012/0013338 A1 offenbart eine Magnetanordnung für Magnetresonanzvorrichtungen, die aus mindestens zwei Ringen unterschiedlicher Magnetisierungsrichtung. In einer Ausführungsform ist ein zentraler Halbach-Ring (siehe dortige Figur 13) angeordnet, der von zwei radial magnetisierten Ringen flankiert ist. Ziel dieser bekannten Vorrichtung ist es, ein in der Magnetisierungsrichtung einstellbares Magnetfeld zu erhalten, das von 0° bis 90°, insbesondere auch um den Magic angle von 54,7° variierbar ist. Ebenfalls sollen die Magnetsegmente orientierbar sein, sodass ein möglichst homogenes Feld im Messvolumen entsteht. Nachteilig ist hierbei allerdings der komplizierte Aufbau, der in der Praxis schwer zu realisieren ist.

Die EP 1 876 462 A1 offenbart eine Stapelung von mindestens zwei Magnetringen, die um einen Proberaum angeordnet und gegeneinander drehbar gelagert sind. Die Einzelringe weisen vorzugsweise eine Halbach-Geometrie auf. Durch die Verdrehung der Ringe kann ein Feld-Sweep erzielt werden, wie er bei der ESR Technik verwendet wird. Im Vordergrund steht bei dieser Anordnung nicht, die nominale Stärke des magnetischen Feldes während des Betriebes variieren zu können, sondern die Homogenität zu verbessern. Dazu sind laterale Verschiebungen der Ringe wesentlich, eine axiale Drehbarkeit ist zwar gegeben, spielt hier aber eine nur untergeordnete Rolle. In der EP 1 876 462 A1 wird eine konzentrische Anordnung vorgeschrieben. Per Definition liegt Konzentrizität vor, wenn die Mittelpunkte identisch sind, was jedoch bei Ringen, die entlang einer gemeinsamen Achse angeordnet sind, nicht gegeben ist. Die in der EP 1 876 462 A1 beschriebenen Magnetgruppen sind weder entlang der z-Achse verschiebbar, noch transversal dazu. Der einzige beanspruchte Freiheitsgrad beschränkt sich auf die gegenseitige Verdrehbarkeit. Dies ist in der bekannten Anordnung möglich, gerade weil die Magnetgruppen koaxial angeordnet sind, also die gleiche Drehachse haben.

Auch bei US-A 4,355,236 und US-A 4,862,128 werden Permanentmagnetringe in Halbach-Konfiguration (QUADRUPOL) als Stapel von mehreren Ringen offenbart, die gegeneinander verdrehbar gelagert sind, sodass der magnetische Fluss im Messvolumen variiert werden kann. Die Ringe sind allerdings nicht gegeneinander exzentrisch in der x-y-Ebene verschiebbar und können auch nicht in z-Richtung beabstandet werden.

In der US-A 4,355,236 wird ein Multipol-Magnet beschrieben, insbesondere wird ausschließlich auf Quadrupole verwiesen, was in der beabsichtigten Verwendung als Fokussierungselement für einen geladenen Teilchenstrahl begründet liegt. Quadrupole stellen nämlich in Teilchenbeschleunigern *das* zentrale Fokussierungselement schlechthin dar (siehe auch FODO Struktur).

Die Einzelmagnetringe müssen zu diesem Zweck verdrehbar sein um je nach Bedarf ein Feld auch Auslöschen zu können, dementsprechend ist die Verdrehbarkeit auch bis zu 45° erforderlich. Des Weiteren ist der zu fokussierende Teilchen-, insbesondere Elektronenstrahl, sehr klein im Vergleich zu einem üblichen MR-Messvolumen. Daher sind auch die Anforderungen an die Homogenität der Anordnung nach der US-A 4,355,236 bei weitem nicht so hoch wie bei einem MR-Dipol. Die in der US-A 4,355,236 beschriebenen Magnetgruppen sind weder entlang der z-Achse verschiebbar, noch transversal dazu. Somit ist die US-A 4,355,236 bezüglich der eingangs definierten gattungsgemäßen Anordnung als eher ferner liegend anzusehen, zumal eventuelle Anwendungen für NMR oder EPR in der US-A 4,355,236 gar nicht erwähnt werden.

Der für die vorliegende Erfindung relevante Offenbarungsgehalt der US-A 4,862,128 ist demjenigen der oben diskutierten US-A 4,355,236 sehr ähnlich. Die US-A 4,862,128 legt sich aber nicht auf ein bestimmtes Anwendungsgebiet fest, sondern lediglich auf die "Erzeugung eines homogenen Magnetfelds". Auch die hier beschriebenen Magnetgruppen sind weder entlang der z-Achse verschiebbar, noch transversal dazu. Es ist die Rede von einem linearen Array, jedoch nicht von einer Verschiebbarkeit zur Realisierung beziehungsweise Verbesserung der Homogenität.

Die eingangs zitierte EP 2 144 076 B1 offenbart eine Halbach Architektur aus drei Ringen, wobei ein zentraler Magnetring von zwei Kopfringen flankiert wird. Die Ringe sind zum Zwecke der Feldhomogenisierung gegenseitig in Längsrichtung mittels Schrauben oder Gewindemuttern verschiebbar, wie aus den Abschnitten [0021]-[0025] und [0040] sowie der dortigen Figur 7 hervorgeht. In EP 2 144 076 B1 ist weiterhin offenbart, dass die Ringe aus Einzelsegmenten bestehen, die abwechselnd trapezförmig und rechteckig sind, wobei die einzelnen Segmente zur Feldhomogenisierung in Radialrichtung verschiebbar sind. Dieser Magnet ist nach EP 2 144 076 B1 aufgebaut und hat 64 mechanische Freiheitsgrade. Diese einzustellen ist in jedem Fall ziemlich aufwändig. Außerdem besteht die Anordnung nach EP 2 144 076 B1 nicht aus fest vormontierten Halbachringen, welche aus trapezförmigen Einzelbestandteilen hergestellt sind. Auch sind die Ringe gegeneinander in Querrichtung bzw. mittels Drehbewegung gegeneinander nicht verschiebbar. Nachteilig ist demgemäß, dass der Aufbau und die Montage sehr kompliziert und aufwändig sind. Wahrscheinlich erreicht die Anordnung auch nicht Feldstärken von 1,9T, da aufgrund des mechanischen Aufbaus nicht das volle Volumen nutzbar ist. Explizit offenbart EP 2 144 076 B1 jedenfalls lediglich eine maximale Feldstärke von 0,7T.

### Aufgabe der Erfindung

Der vorliegenden Erfindung liegt demgegenüber die Aufgabe zugrunde, mit einfachen technischen Maßnahmen und ohne Volumenzunahme eine Permanentmagnetanordnung der eingangs definierten Art für eine MR-Vorrichtung bereitzustellen, die mehrere Ringe in Halbach-Konfiguration umfasst und die wesentlich einfacher zu montieren und somit deutlich kostengünstiger herzustellen ist. Gleichzeitig soll es ermöglicht werden, die aufgrund der Montage bedingten Magnetfeld-Gradienten zu minimieren. Es soll also eine Halbach-Anordnung vorgestellt werden, die mit wesentlich weniger mechanischen Shim-Freiheitsgraden auskommt.

### Kurze Beschreibung der Erfindung

Diese Aufgabe wird durch die vorliegende Erfindung auf ebenso überraschend einfache wie wirkungsvolle Weise dadurch gelöst, dass die ringförmigen Magnetelemente bereits vor einer Endmontage in der Magnetresonanz-Apparatur fest vorgefertigt und ihre jeweiligen Magnetsegmente unverschiebbar gegeneinander fixiert sind, dass die ringförmigen Magnetelemente so gelagert sind, dass sie relativ zueinander parallel zur verschoben werden können, und dass die ringförmigen Magnetelemente relativ zueinander verdrehbar und/oder verkippbar gelagert sind.

Erfindungsgemäß wird eine Magnetvorrichtung vorgeschlagen, die aus fest verklebten Ringen von Halbach-Magneten aufgebaut ist. Die entstandenen Fertigungstoleranzen bzw. die daraus resultierenden Inhomogenitäten werden durch Bewegen der einzelnen Ringe gegeneinander minimiert.

Die vorgeschlagene Magnetanordnung besitzt kein Joch und besteht aus mindestens 2 ringförmigen segmentierten Magnetbaugruppen, deren Magnetisierung ein Halbach-Schema annähert. Die Ringbaugruppen sind in bestimmter Weise gegeneinander justierbar. Da die Ringbaugruppen als Ganzes und nicht einzelne Segmente justiert werden, reduziert sich die Anzahl der möglichen Freiheitsgrade auf maximal drei pro Ring. Wesentlich ist, dass der Homogenisierungsprozesse mit diesen wenigen Freiheitsgraden vereinfacht wird.

Daher ist der vorliegende erfindungsgemäße Lösungsansatz dahingehend gerichtet, die Permanentmagnetsegmente zu Ringbaugruppen zusammenzufassen. Positionierung der Ringe zueinander hat die notwendigen Freiheitsgrade um die priorisierten Fehlordnungen durch einfache Bewegungsabläufe korrigieren zu können.

So ist bei der vorliegenden Erfindung der mittlere Ring als Ganzes fest verklebt und als Ganzes lateral gegen den oberen und unteren Ring verschiebbar. Es werden also nicht einzelne Segmente verschoben, sondern der gesamte mittlere Ring (2 Freiheitsgrade). Zusätzlich sind noch weitere mechanische Freiheitsgrade eingebaut: Die Höhenverschiebung und Drehung des oberen und unteren Ringes (jeweils zwei Freiheitsgrade). Man hat hier also nur 6 mechanische Freiheitsgrade. Diese werden vorrangig zum Shimmen der Lineargradienten genutzt. Zusätzlich ist ein Shimrohr (ähnlich wie in den bekannten MRI Magneten der Anmelderin) zum Shimmen der höheren Feldordnungen vorhanden.

Hintergrund ist der "eisenlose" Magnet, basierend auf Halbach-annähernder Magnetisierung. Es gibt bereits verschiedene publizierte Halbach-artige Realisierungen, deren Aufbau meist mit vielen einzeln justierbaren Magnetsegmenten verbunden ist, was einen relativ aufwändigen Homogenisierungsprozess zur Folge hat. Sehr viele Freiheitgrade sind möglich.

Der erfindungsgemäße Ansatz reduziert das Ganze auf mehrere Ringbaugruppen, d.h. mindestens zwei segmentierte Halbach-Ringe, die jedoch sowohl axial als auch transversal leicht verschiebbar gelagert sind und zusätzlich um einen kleinen Winkel gegeneinander verdreht werden können.

Diverse Ausprägungen sind möglich: Unter anderem werden bei Erfindung aktuell drei Ringe mit unterschiedlichen Innen- und Außenradien und Dicken benutzt. Die Ringbaugruppen "schweben" natürlich nicht frei im Raum, sondern besitzen eine Haltestruktur und Elemente zur Fixierung der Position, die aber hier nicht im Einzelnen beschrieben werden sollen. Mit diesem erfindungsgemäßen Konzept wurde eine mit vertretbarem Aufwand homogenisierbare Anordnung gefunden, die bisher noch nicht existiert hat. Der Aufbau mit unabhängigen Ringbaugruppen zeitigt auch Vorteile für Montage.

Die magnetischen Bauteile sind zudem durch den erfindungsgemäßen Aufbau gegen unerwünschte Bewegungen gesichert. Auf Grund der geometrischen Form hindern sich benachbarte Bauteile im montierten Zustand an einer ungewollten Bewegung. Durch die formschlüssige Anordnung der Magnetbaugruppen ergibt sich eine Eigensicherheit des Systems:
Der rotationssymmetrische Aufbau aufgrund der zylindrischen Geometrie passt sich optimal an die Form des Messvolumens an, so dass der Materialeinsatz durch die kürzere mittlere Eisenweglänge im Vergleich zu rechteckigen Anordnungen wesentlich effizienter ist.

### Wesentliche Vorteile der Erfindung gegenüber dem Stand der Technik:

Reduzierung der üblicherweise großen Anzahl von Freiheitsgraden auf ein Minimum, welches jedoch effektives mechanisches Shimmen ermöglicht.

Mechanische Assemblierung der einzelnen Ringbaugruppen ohne weitere komplizierte Stellmechanismen, wie bewegliche Magnete, Nebenschlüsse und dergleichen.

Rotationssymmetrie: Dadurch können die Chassis-Bauteile auf einer simplen Drehmaschine gefertigt werden. Des Weiteren wird eine bequeme sequentielle Montage auf einer Drehplattform ermöglicht.

Sicherheit: Eigensicherung durch formschlüssige Anordnung der Magnetbaugruppen und Jochteile. Im zusammengebauten Zustand sind alle Magnete gegen relative Bewegungen gesichert.

### Bevorzugte Ausführungsformen und Weiterbildungen der Erfindung

Besonders bevorzugt ist eine Ausführungsform der erfindungsgemäßen Magnetanordnung, bei der die ringförmigen Magnetelemente um die z-Achse verdrehbar gelagert sind. Herstellungsbedingte Schwankungen der ringförmig zusammengesetzten Segmente können eine Winkelabweichung der magnetischen Achse eines gesamten Rings hervorrufen. Durch die beschriebene Ausführungsform, kann diese Winkelabweichung mittels Einstellen eines entsprechenden Winkels im Gegensinn korrigiert werden.

Weitere vorteilhafte Ausführungsformen sind dadurch gekennzeichnet, dass die ringförmigen Magnetelemente konzentrisch um die z-Achse angeordnet sind, und dass die radial äußeren ringförmigen Magnetelemente fest, das radial innere ringförmige Magnetelement beweglich gelagert sind. Zur Homogenisierung des Magneten müssen unter Anderem lineare Feldgradienten transversal zur z-Achse minimiert werden. Durch die bewegliche Lagerung des zentralen Magnetrings bietet sich eine Möglichkeit vorwiegend Lineargradienten zu beeinflussen. Indem nur ein Teil der Magnetmasse bewegt werden kann, ergibt sich eine feinere Auflösung des erzielbaren Einstellbereichs. Weiterhin bietet der feststehende Teil die erforderlichen Auflage- und Führungsfläche für den beweglichen Teil und verfügt über die notwendigen Zug- oder Druckmechanismen zur Fixierung der Endposition.

Eine weitere vorteilhafte Ausführungsform sieht vor, dass die ringförmigen Magnetelemente konzentrisch um die z-Achse angeordnet sind, und dass das radial innere ringförmige Magnetelement eine höhere Koerzitivfeldstärke aufweist als die radial äußeren ringförmigen Magnetelemente. Entsprechend der magnetischen Feldstärken innerhalb der in der Magnetanordnung enthaltenen Segmente, können entsprechend der Koerzitivfeldstärke des verwendeten Magnetmaterials irreversible Demagnetisierungseffekte auftreten, die die Apparatur unbrauchbar machen würden. Durch Verwendung eines Materials mit entsprechend hoher Koerzitivfeldstärke kann dies verhindert werden. Da Materialien höherer Koerzitivität typischerweise niedrigere Remanenz aufweisen, ist eine Kombination von hochremanentem Material (zu größeren Radien hin) mit hochkoerzitivem Material (zu kleineren Radien hin) am effektivsten in Bezug auf den gesamten Materialeinsatz.

Eine bevorzugte Ausführungsform ist dadurch gekennzeichnet, dass die ringförmigen Magnetelemente in z-Richtung übereinander gestapelt angeordnet sind, dass das Permanentmagnetsystem mindestens 3 ringförmige Magnetelemente aufweist, und dass das mittlere ringförmige Magnetelement als Ganzes fest verklebt und als Ganzes lateral gegen das obere und untere ringförmige Magnetelement verschiebbar ist. Diese Anordnung ermöglicht eine Montage der einzelnen Ringbaugruppen (ggf. aus unterschiedlichen Materialien) als in sich geschlossene Baugruppen und bringt die für die Homogenisierung erforderliche Mindestzahl an mechanischen Freiheitsgraden mit sich.

Vorteilhaft ist auch eine Ausführungsform, bei der die ringförmigen Magnetelemente in z-Richtung übereinander gestapelt angeordnet sind, und dass das mittlere ringförmige Magnetelement nur in der x-y-Ebene beweglich und die oberen und unteren ringförmigen Magnetelemente in z-Richtung verschiebbar und verdrehbar sind. Mit dieser Kombination lassen sich die erforderlichen Stellhübe für die Homogenisierung mit einem Minimum an mechanischen Freiheitsgraden erzielen. Die dabei beeinflussten Feldordnungen sind dabei weitgehend voneinander entkoppelt, was den Homogenisierungsvorgang deutlich vereinfacht. Siehe oben: Beispielsweise werden durch den transversalen Versatz der zentralen Ringbaugruppefast ausschließliche lineare Feldgradienten beeinflusst.

Eine weitere vorteilhafte Ausführungsform der erfindungsgemäßen Magnetanordnung zeichnet sich dadurch aus, dass die ringförmigen Magnetelemente in z-Richtung übereinander gestapelt angeordnet sind, und dass das mittlere ringförmige Magnetelement aus zwei konzentrischen Magnetringen aufgebaut ist, die derart gegenseitig befestigt sind, vorzugsweise über Stege, dass zwischen den Ringen Aussparungen für eine Einführung von Korrekturelementen bzw. Shimstrukturen verbleiben. Diese Aussparungen bieten abseits von den beschriebenen mechanischen Freiheitsgraden zusätzlich eine Möglichkeit komplexere Korrekturen z.B. durch einbringen von zusätzlichem Magnetmaterial vorzunehmen. Entsprechend der Ausgestaltung dieser Shimstrukturen sind sehr fein aufgelöste Stellhübe realisierbar.

Besonders bevorzugt ist eine Ausführungsform, bei der die ringförmigen Magnetelemente in z-Richtung übereinander gestapelt angeordnet sind, und das mittlere ringförmige Magnetelement in der x-y-Ebene schwimmend gelagert ist, wobei Haltevorrichtungen, insbesondere Kulissensteine vorgesehen sind, die durch Öffnungen in der Gehäusevorrichtung hindurchragen und mit welchen die X-Y-Position des mittleren ringförmigen Magnetelements einstellbar ist.
Die konzentrische Anordnung der Ringbaugruppen führt dazu, dass die innenliegenden Baugruppen von außen nicht mehr zugänglich sind. Erst durch die Kulissensteine und/oder weitere Verbindungselemente werden die Angriffspunkte für die Positionseinstellung der zentralen Ringbaugruppe durch Wandöffnungen hindurch an den äußeren Umfang verlegt und so die Verstellbarkeit ermöglicht.

Ganz besonders bevorzugt ist eine Ausführungsform der Erfindung, bei der eine Einrichtung zur Homogenisierung des Magnetfelds, vorzugsweise ein Shim-Rohr, zum Shimmen der höheren Feldordnungen vorhanden ist. Die im Vorfeld beschriebenen Mechanismen werden auf diese Weise durch ein weiteres noch präziseres Instrument zur Homogenisierung ergänzt. Damit sind noch feiner auflösende Korrekturen möglich.

Eine Klasse von besonders bevorzugten Ausführungsformen der erfindungsgemäßen Magnetanordnung zeichnet sich dadurch aus, dass das Permanentmagnetsystem in Richtung der z-Achse beidseitig von zwei Deckelbaugruppen begrenzt ist, die je ein ringförmiges Magnetelement und ein Deckelbauteil umfassen, mit welchem die ringförmigen Magnetelemente an einer Gehäusevorrichtung verdrehbar und in z-Richtung verschiebbar sowie an der Gehäusevorrichtung befestigbar sind. Die Beschaffenheit des Magnetmaterials ist ungeeignet, um Befestigungselemente wie Gewinde oder Ähnliches aufzunehmen. Um den Magnetsementen sicheren Halt zu bieten und Flächen für die Befestigung mechanischer Halte- und Justiervorrichtungen zu schaffen, erfolgt die Teilmontage in den beschriebenen Deckelbaugruppen, die außerdem die Vorrichtungen zur Verdrehung und Fixierung der drehbar gelagerten Baugruppen aufnehmen, sowie Abdruck-/Abstützelemente für die Abstandseinstellung entlang der z-Achse beinhalten.

Vorteilhafte Weiterbildungen dieser Klasse von Ausführungsformen sind dadurch gekennzeichnet, dass Positioniermittel, insbesondere Stellschrauben, vorhanden sind, mit welchen die Deckelbaugruppen relativ zur Gehäusevorrichtung aus der x-y-Ebene verkippbar und um die z-Achse verdrehbar sind. Durch asymmetrische Einstellung der Positioniermittel, kann eine leichte Neigung / Verkippung der Ringbaugruppen eingestellt werden, um ihrerseits Asymmetrien der Baugruppen selbst auszugleichen.

In den Rahmen der vorliegenden Erfindung fällt auch ein Verfahren zur Herstellung einer Magnetanordnung gemäß der oben beschriebenen Ausführungsform oder ihrer Weiterbildung, umfassend folgende Schritte:
(a) Verkleben der vormagnetisierten Magnetsegmente zu Magnetringen, vorzugsweise innerhalb eines Halterings;
(b) Herstellen einer mittleren Magnetringbaugruppe durch Einbringen eines Magnetrings in eine zentrale ringförmige Gehäusevorrichtung mit mindestens zwei Öffnungen und Befestigen des Magnetrings durch Haltevorrichtungen, welche durch die Öffnungen in der Gehäusevorrichtung an dem Magnetring anmontiert werden, so dass der Magnetring in der Gehäusevorrichtung schwimmend gelagert ist;
(c) Anbringen einer Führungsanordnung an der mittleren Magnetringbaugruppe sowie an den Deckelbaugruppen und Zusammenfügen der Magnetringe gegen die Abstoßungskräfte der Magneten;
(d) Fixieren der Deckelbauteile an der Gehäusevorrichtung;
(e) iteratives Vermessen der Feldhomogenität und Einstellen der Position der Magnetringe zueinander mit Hilfe von Positioniermitteln;
(f) Entfernen der Führungsanordnung.

Bei der Montage bereits magnetisierter Permanentmagnete treten Anziehungs- und Abstoßungskräfte in der Größenordnung mehrerer Tonnen auf. Diese Kräfte müssen während der Bestückung abgestützt bzw. aufgefangen werden, um die Magnetelemente sicher an die vorgesehenen Positionen zu bringen. Das ist mit dem hier beschriebenen Montageverfahren besonders gut möglich.

Vorzugsweise verwendet man gegenüberliegende Durchgangslöcher, damit der Magnetring im Gehäuse besser beweglich ist. Es geht aber auch mit drei Öffnungen, die sich nicht gegenüber liegen.

Die Führungsanordnung in Schritt (c) dient dazu, Transversalbewegungen zu verhindern. Das kann etwa mittels einer oder mehrerer Schiene(n) oder Stange(n) realisiert werden. Jedoch hat eine Schiene per Definition keine weiteren Freiheitsgrade, um gegebenenfalls den mittleren Ring in einer alternative Ausgestaltung der Erfindung in die Endposition einzudrehen.

Vorzugsweise sind die Baugruppen derart an der Führungsanordnung angebracht, dass eine Baugruppe fest mit der Führungsanordnung verbunden ist und die beiden anderen Baugruppen mit Gleitbuchsen versehen sind. Durch eine Schub- oder Zugvorrichtung werden die äußeren Baugruppen entlang der z-Achse aufeinander zu bewegt, wobei die dazwischen befindliche mittlere Baugruppe in entlang der z-Achse beweglich bleibt. Auf Grund der Symmetrie der Anordnung und der damit einhergehenden Symmetrie der Abstoßungskräfte, wird sich die mittlere Baugruppe stets in gleichem Abstand zu beiden äußeren Baugruppen positionieren. Auf diese Weise wird ein gleichmäßiger Fügeprozess und symmetrische Spaltmaße bis zum Erreichen der Endposition ermöglicht. Die Magnetringe können beispielsweise mit Hilfe einer Spindel zusammengefügt werden.

Das iterative Vermessen der Feldhomogenität sowie die Einstellung der Position des mittleren Rings in der x-y-Ebene in Schritt (e) kann mittels Zug- und Druckschrauben oder Druckfedern erfolgen, ebenso das Einstellen des Abstands der beiden Deckelbaugruppen, und Homogenisieren des Feldes durch Rotation der Deckelbaugruppen.

Bei einer vorteilhaften Variante des erfindungsgemäßen Verfahrens wird vor der Einstellung der Feldhomogenität in Schritt (e) hilfsweise eine äußere Brücke an der Gehäusevorrichtung angebracht. Anschließend wird die Deckelbaugruppe von der Gehäusevorrichtung gelöst, wodurch die Deckelbaugruppen verschiebbar und verdrehbar gegenüber der mittleren Magnetringbaugruppe gelagert werden.

In einer weiteren bevorzugten Verfahrensvariante ist vorgesehen, dass nach dem Einstellen der Feldhomogenität in Schritt (e) Abstandshalter eingebracht werden, wo Spalten zwischen den Magnetringen belassen werden sollen.

Schließlich fällt in den Rahmen der vorliegenden Erfindung auch ein Verfahren zur Homogenisierung des Magnetfelds einer Magnetanordnung nach einem der vorhergehenden Ansprüche, umfassend folgende Schritte:
Justieren der Magnetringe als ganze, starre Baugruppen;
Verbessern die Homogenität des Magnetfelds im Messvolumen (MV) durch laterale Verschiebung der Ringe und/oder Verkippung gegenüber der z-Achse und/oder Verdrehen um die z-Achse.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in den Figuren und Diagrammen der Zeichnung dargestellt und wird anhand von Ausführungsbeispielen näher erläutert.

Es zeigen:
- Fig.1a: eine schematische räumliche Explosions-Darstellung einer Ausführungsform der erfindungsgemäßen Magnetanordnung;
- Fig.1b: wie Fig.1a, jedoch als Halbschnitt;
- Fig. 2: eine schematische räumliche Gesamtansicht einer weiteren Ausführungsform der erfindungsgemäßen Magnetanordnung und einer Ausführungsform der zur Montage erforderlichen Führungsanordnung
- Fig.3a: eine schematische räumliche Darstellung einer Ausführungsform der erfindungsgemäßen Magnetanordnung mit sechs Halbach-Ringen in längs der z-Richtung gestapelter Anordnung als Explosions-Darstellung im auseinandergezogenen Zustand;
- Fig.3b: eine mittlere Magnetanordnung aus Fig.3a mit Shimrohr;
- Fig.4: einen schematischen Vertikal-Schnitt durch eine Ausführungsform mit koaxial um die z-Achse herum angeordneten Ringelementen;
- Fig.5: eine skizzierte Ausführungsform mit mehr als drei auf der z-Achse angeordneten, segmentierten Ringelementen als Explosions-Darstellung im auseinandergeschobenen Zustand; und
- Fig. 6: Verlaufsschema der Verfahrensschritte bei der Herstellung eines erfindungsgemäßen Magneten.

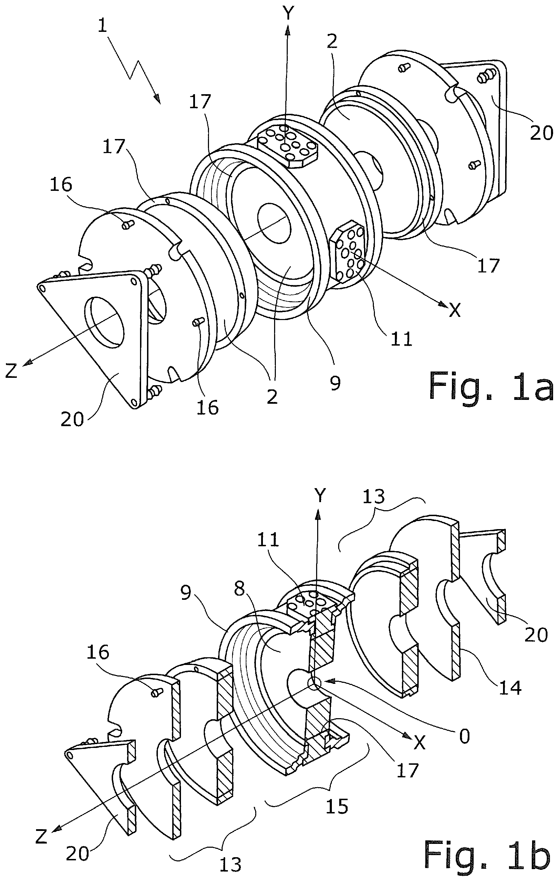

Die erfindungsgemäße **Magnetanordnung 1**, wie sie in den Figuren der Zeichnung in verschiedenen Ausführungsformen jeweils schematisch dargestellt ist, findet ihre Hauptanwendung als Bestandteil einer -in der Zeichnung nicht eigens dargestellten- Magnetresonanz-Apparatur mit einem Permanentmagnetsystem zur Erzeugung eines homogenen Magnetfeldes in Richtung einer z-Achse in einem (in Fig. 1b angedeuteten) **Messvolumen 0**, wobei das Permanentmagnetsystem mindestens zwei, insbesondere mindestens drei, bezüglich der z-Achse zylindersymmetrisch und in z-Richtung übereinander gestapelt und/oder konzentrisch angeordnete, ringförmige **Magnetelemente 2** aus magnetischem Material umfasst, wobei die ringförmigen Magnetelemente 2 aus einzelnen **Magnetsegmenten 3** aufgebaut und so angeordnet sind, dass die Magnetisierungsrichtung der Einzelsegmente in den jeweiligen Ringen im Wesentlichen parallel in einer zur z-Richtung senkrechten x-y-Ebene verläuft, wobei die ringförmigen Magnetelemente 2 jeweils eine Halbach-Magnetisierung aufweisen, die ein magnetisches Dipolfeld erzeugt, und wobei die ringförmigen Magnetelemente 2 relativ zueinander in mehreren Freiheitsgraden ausrichtbar sind.
Generell zeichnet sich die Magnetanordnung 1 gemäß der vorliegenden Erfindung dadurch aus, dass die ringförmigen Magnetelemente 2 bereits vor einer Endmontage in der Magnetresonanz-Apparatur fest vorgefertigt und ihre jeweiligen Magnetsegmente 3 unverschiebbar gegeneinander fixiert sind, dass die ringförmigen Magnetelemente 2 relativ zueinander in der x-y-Ebene verschiebbar angeordnet sind, und dass die ringförmigen Magnetelemente 2 relativ zueinander verdrehbar und/oder verkippbar gelagert sind.

Vorzugsweise werden die ringförmigen Magnetelemente 2 um die z-Achse verdrehbar gelagert sein.

Die ringförmigen Magnetelemente 2 können konzentrisch um die z-Achse angeordnet sein, wobei die **radial äußeren ringförmigen Magnetelemente 5** fest, das **radial innere ringförmige Magnetelement 4** beweglich gelagert sind oder umgekehrt.

Auch können die ringförmigen Magnetelemente 2 konzentrisch um die z-Achse angeordnet sein, wobei das radial innere ringförmige Magnetelement 4 eine höhere Koerzitivfeldstärke aufweist als die radial äußeren ringförmigen Magnetelemente 5.

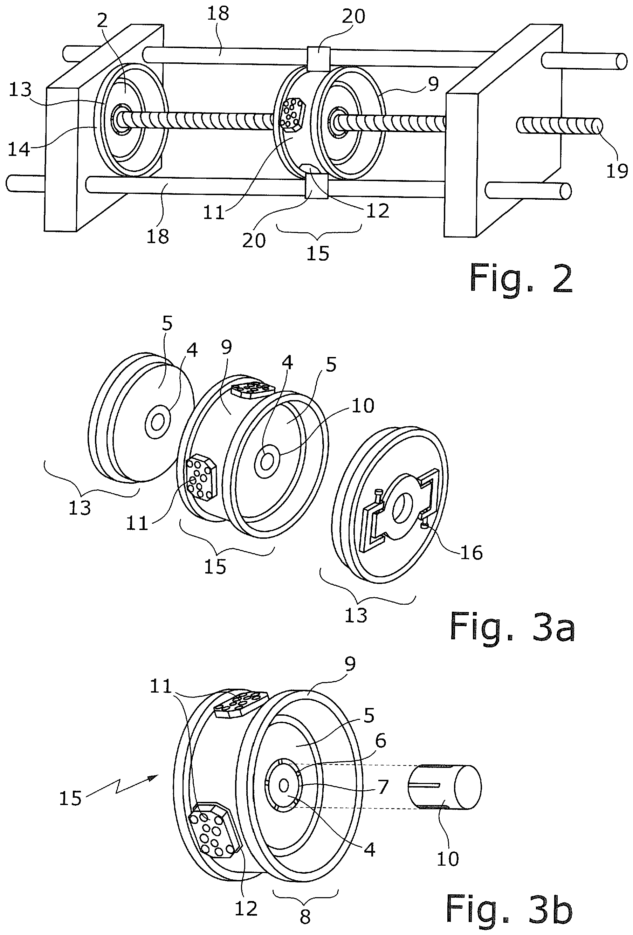

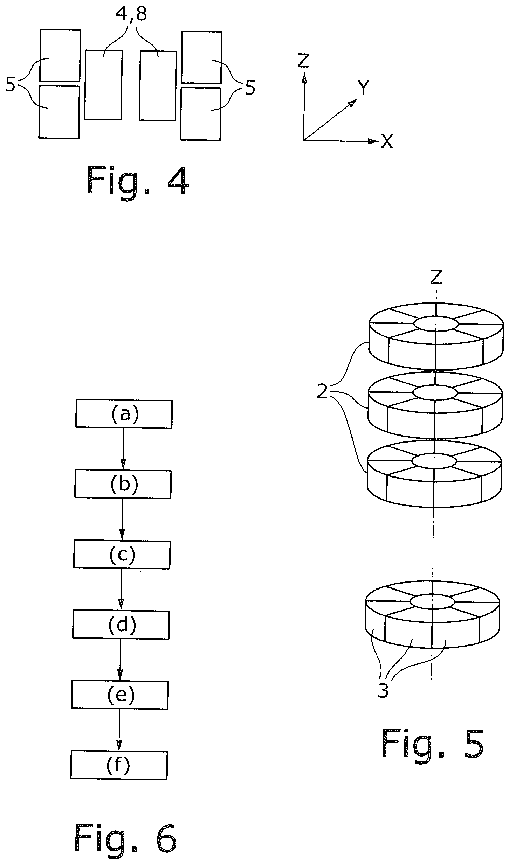

Bei Ausführungsformen der Erfindung sind die ringförmigen Magnetelemente 2 in z-Richtung übereinander gestapelt angeordnet. Das Permanentmagnetsystem weist dann mindestens drei ringförmige Magnetelemente 2 auf, wie in den Figuren 1a, 1b und 2 gut zu erkennen ist. Das **mittlere ringförmige Magnetelement 8** -wie in den Figuren 3b und 4 dargestellt- ist dort als Ganzes fest verklebt und als Ganzes lateral gegen das obere und untere ringförmige Magnetelement verschiebbar.

Die ringförmigen Magnetelemente 2 können in z-Richtung übereinander gestapelt angeordnet sein, wie in den Figuren 1 a bis 3a sowie 5 gezeigt.
Bei einfacheren Weiterbildungen kann dann das mittlere ringförmige Magnetelement 8 so gestaltet sein, dass es nur in der x-y-Ebene beweglich ist, während die oberen und unteren ringförmigen Magnetelemente auch in z-Richtung verschiebbar und verdrehbar sind.

Auch kann das mittlere ringförmige Magnetelement 8 aus zwei konzentrischen Magnetringen 4,5 aufgebaut sein, wie etwa in den Figuren 3a, 3b und 4 gut zu erkennen ist. Diese sind -vorzugsweise über **Stege 6**, wie in Fig. 3b dargestellt- derart gegenseitig befestigt, dass zwischen den Ringen **Aussparungen 7** für eine Einführung von **Korrekturelementen 10** zur Homogenisierung des Magnetfelds, etwa Shimstrukturen wie ein Shim-Rohr zum Shimmen der höheren Feldordnungen, verbleiben.

Das mittlere ringförmige Magnetelement 8 kann in der x-y-Ebene schwimmend gelagert sein, wobei **Haltevorrichtungen 11**, insbesondere Kulissensteine, vorgesehen sind, die durch -in Fig. 2 angedeutete- **Öffnungen 12** in der **Gehäusevorrichtung 9** hindurchragen und mit welchen die X-Y-Position des mittleren ringförmigen Magnetelements 8 einstellbar ist. Die Einstellung der X-Y-Position erfolgt mittels Positioniermitteln (nicht in der Figur abgebildet), beispielsweise in Form von Zug- oder Druckschrauben in den Kulissensteinen.

In den Figuren 1a bis 3a sind Ausführungsformen dargestellt, welche sich dadurch auszeichnen, dass das Permanentmagnetsystem in Richtung der z-Achse beidseitig von zwei **Deckelbaugruppen 13** begrenzt ist, die je ein ringförmiges Magnetelement und ein **Deckelbauteil 14** umfassen, mit welchem die ringförmigen Magnetelemente 2 an einer Gehäusevorrichtung 9 verdrehbar und in z-Richtung verschiebbar sowie an der Gehäusevorrichtung 9 befestigbar sind. Die Deckelbaugruppen 13 sowie das Deckelbauteil 14 schließen dabei jeweils axial an eine **mittlere Magnetringbaugruppe 15** an.

In der Regel werden bei der erfindungsgemäßen Magnetanordnung 1 **Positioniermittel 16** vorhanden sein, insbesondere auch Stellschrauben in unterschiedlichen geometrischen Ausformungen und räumlichen Platzierungen, mit welchen die Deckelbaugruppen 13 relativ zur Gehäusevorrichtung 9 aus der x-y-Ebene verkippbar und/oder um die z-Achse verdrehbar sind.

Die Figuren 1a und 1b zeigen auch **Halteringe 17**, innerhalb deren die Magnetringe 2 angeordnet sind.

Fig. 2 zeigt eine Anordnung zur Montage einer erfindungsgemäßen Magnetanordnung mit einer **Führungsanordnung 18** sowie einer **Spindel 19**, die an der mittleren Magnetringbaugruppe 15 sowie an den Deckelbaugruppen 13 angebracht werden, um ein Zusammenfügen der Magnetringe 2 auch gegen die Abstoßungskräfte der Magneten einfach zu ermöglichen. Die Führungsanordnung 18 und die Spindel 19 werden nach der Montage wieder entfernt. Alternativ zur Spindel 19 kann auch beispielsweise eine hydraulische Presse oder ähnliches verwendet werden.

Vor der Einstellung der Feldhomogenität kann eine **äußere Brücke 20** an der Gehäusevorrichtung 9 angebracht werden. Anschließend wird die Deckelbaugruppe 13 von der Gehäusevorrichtung 9 gelöst, wodurch die Deckelbaugruppen 13 verschiebbar und verdrehbar gegenüber der mittleren Magnetringbaugruppe 15 gelagert werden. Wie in Fig. 1a zu erkennen ist, wird mit Hilfe der Brücke 20 die Deckelbaugruppe 13 derart am Gehäuse 9 befestigt, dass die Deckelbaugruppe 13 innerhalb der Brücke ausreichend Spiel hat, dass die Deckelbaugruppe um die Z-Achse verdrehbar oder verkippbar ist.

Nach dem Einstellen der Feldhomogenität werden -in der Zeichnung nicht eigens dargestellte- Abstandshalter jeweils an den Stellen eingebracht, wo Spalten zwischen den Magnetringen 2 belassen werden sollen.

Das Magnetfeld einer erfindungsgemäßen Magnetanordnung 1 kann durch Justieren der Magnetringe 2 als ganze, starre Baugruppen 13,15 -wie in den Figuren 1a bis 2 dargestellt- homogenisiert werden. Zur weiteren Verbesserung der Homogenität des Magnetfelds im Messvolumen 0 können laterale Verschiebungen der Magnetringe 2 und/oder Verkippungen gegenüber der z-Achse und/oder Verdrehungen um die z-Achse durchgeführt werden.

### Bezugszeichenliste

0. Messvolumen
1. Magnetanordnung
2. ringförmige Magnetelemente
3. Magnetsegmente
4. radial inneres ringförmiges Magnetelement
5. radial äußeres ringförmiges Magnetelement
6. Stege
7. Aussparungen für Shims
8. mittleres ringförmiges Magnetelement
9. Gehäusevorrichtung
10. Korrekturelemente
11. Haltevorrichtungen
12. Öffnungen
13. Deckelbaugruppen
14. Deckelbauteil
15. mittlere Magnetringbaugruppe
16. Positioniermittel
17. Haltering
18. Führungsanordnung
19. Spindel
20. Brücke

## Patentansprüche

1. Magnetanordnung (1) für den Einsatz in einer Magnetresonanz-Apparatur mit einem Permanentmagnetsystem zur Erzeugung eines homogenen Magnetfeldes in Richtung senkrecht zu einer z-Achse in einem Messvolumen (0), wobei das Permanentmagnetsystem mindestens zwei, insbesondere mindestens drei, bezüglich der z-Achse zylindersymmetrisch und in z-Richtung übereinander gestapelt und/oder konzentrisch angeordnete, ringförmige Magnetelemente (2) aus magnetischem Material umfasst, wobei die ringförmigen Magnetelemente (2) aus einzelnen Magnetsegmenten (3) aufgebaut und so angeordnet sind, dass die Magnetisierungsrichtung der Einzelsegmente in den jeweiligen Ringen im Wesentlichen parallel zu einer zur z-Richtung senkrechten, zu einer x-y-Ebene parallelen Ebene verläuft, wobei die ringförmigen Magnetelemente (2) jeweils eine Halbach-Magnetisierung aufweisen, die ein magnetisches Dipolfeld erzeugt, und wobei die ringförmigen Magnetelemente (2) relativ zueinander in z-Richtung ausrichtbar sind,
**dadurch gekennzeichnet,**
**dass** die ringförmigen Magnetelemente (2) bereits vor einer Endmontage in der Magnetresonanz-Apparatur fest vorgefertigt und ihre jeweiligen Magnetsegmente (3) unverschiebbar gegeneinander fixiert sind,
**dass** die ringförmigen Magnetelemente (2) so gelagert sind, dass sie relativ zueinander parallel zur x-y-Ebene verschoben werden können, und dass die ringförmigen Magnetelemente (2) relativ zueinander verdrehbar und/oder verkippbar gelagert sind.

2. Magnetanordnung nach Anspruch 1, **dadurch gekennzeichnet, dass** die ringförmigen Magnetelemente (2) um die z-Achse verdrehbar gelagert sind.

3. Magnetanordnung nach einem der vorhergehenden Ansprüche, **dadurch gekennzeichnet, dass** die ringförmigen Magnetelemente (2) konzentrisch um die z-Achse angeordnet sind, und dass radial äußere ringförmige Magnetelemente (5) fest, radial innere ringförmige Magnetelemente (4) beweglich gelagert sind oder umgekehrt.

4. Magnetanordnung nach einem der vorhergehenden Ansprüche, **dadurch gekennzeichnet, dass** die ringförmigen Magnetelemente (2) konzentrisch um die z-Achse angeordnet sind, und dass ein radial inneres ringförmiges Magnetelement (4) eine höhere Koerzitivfeldstärke aufweist als radial äußere ringförmige Magnetelemente (5).

5. Magnetanordnung nach einem der vorhergehenden Ansprüche, **dadurch gekennzeichnet, dass** die ringförmigen Magnetelemente (2) in z-Richtung übereinander gestapelt angeordnet sind, dass das Permanentmagnetsystem mindestens drei ringförmige Magnetelemente (2) aufweist, und dass das mittlere ringförmige Magnetelement (8) als Ganzes fest verklebt und als Ganzes lateral gegen das obere und untere ringförmige Magnetelement verschiebbar ist.

6. Magnetanordnung nach einem der vorhergehenden Ansprüche, **dadurch gekennzeichnet, dass** die ringförmigen Magnetelemente (2) in z-Richtung übereinander gestapelt angeordnet sind, und dass ein mittleres ringförmiges Magnetelement (8) nur in der x-y-Ebene beweglich und obere und untere ringförmige Magnetelemente in z-Richtung verschiebbar und verdrehbar sind.

7. Magnetanordnung nach einem der vorhergehenden Ansprüche, **dadurch gekennzeichnet, dass** Korrekturelemente (10) zur Homogenisierung des Magnetfelds, etwa Shimstrukturen zum Shimmen der höheren Feldordnungen, vorzugsweise ein Shim-Rohr, vorhanden sind.

8. Magnetanordnung nach einem der vorhergehenden Ansprüche, **dadurch gekennzeichnet, dass** die ringförmigen Magnetelemente (2) in z-Richtung übereinander gestapelt angeordnet sind, und dass ein mittleres ringförmiges Magnetelement (8) aus zwei konzentrischen Magnetringen (4,5) aufgebaut ist, die derart gegenseitig befestigt sind, vorzugsweise über Stege (6), dass zwischen den Ringen Aussparungen (7) für eine Einführung von Korrekturelementen (10) zur Homogenisierung des Magnetfelds verbleiben.

9. Magnetanordnung nach einem der vorhergehenden Ansprüche, **dadurch gekennzeichnet, dass** die ringförmigen Magnetelemente (2) in z-Richtung übereinander gestapelt angeordnet sind, und dass ein mittleres ringförmiges Magnetelement (8) in der x-y-Ebene schwimmend gelagert ist, wobei Haltevorrichtungen (11), insbesondere Kulissensteine, vorgesehen sind, die durch Öffnungen (12) in einer Gehäusevorrichtung (9), die Teil der Magnetanordnung (1) ist, hindurchragen und mit welchen die X-Y-Position des mittleren ringförmigen Magnetelements (8) einstellbar ist.

10. Magnetanordnung nach einem der vorhergehenden Ansprüche, **dadurch gekennzeichnet, dass** das Permanentmagnetsystem in Richtung der z-Achse beidseitig von zwei Deckelbaugruppen (13) begrenzt ist, die je ein ringförmiges Magnetelement und ein Deckelbauteil (14) umfassen, mit welchem die ringförmigen Magnetelemente (2) an einer Gehäusevorrichtung (9) verdrehbar und in z-Richtung verschiebbar sowie an der Gehäusevorrichtung (9) befestigbar sind.

11. Magnetanordnung nach Anspruch 10, **dadurch gekennzeichnet, dass** Positioniermittel (16), insbesondere Stellschrauben, vorhanden sind, mit welchen die Deckelbaugruppen (13) relativ zur Gehäusevorrichtung (9) aus der x-y-Ebene verkippbar und/oder um die z-Achse verdrehbar sind.

12. Verfahren zur Herstellung einer Magnetanordnung (1) nach einem der Ansprüche 10 oder 11, umfassend folgende Schritte:
(a) Verkleben der vormagnetisierten Magnetsegmente (3) zu Magnetringen (2), vorzugsweise innerhalb eines Halterings (17);
(b) Herstellen einer mittleren Magnetringbaugruppe (15) durch Einbringen eines Magnetrings (2) in eine zentrale ringförmige Gehäusevorrichtung (9) mit mindestens zwei Öffnungen (12) und Befestigen des Magnetrings (2) durch Haltevorrichtungen (11), welche durch die Öffnungen (12) in der Gehäusevorrichtung (9) an dem Magnetring (2) anmontiert werden, so dass der Magnetring (2) in der Gehäusevorrichtung (9) schwimmend gelagert ist;
(c) Anbringen einer Führungsanordnung (18) an der mittleren Magnetringbaugruppe (15) sowie an den Deckelbaugruppen (13) und Zusammenfügen der Magnetringe (2) gegen die Abstoßungskräfte der Magneten;
(d) Fixieren der Deckelbauteile (14) an der Gehäusevorrichtung (9);
(e) iteratives Vermessen der Feldhomogenität und Einstellen der Position der Magnetringe (2) zueinander mit Hilfe von Positioniermitteln (16);
(f) Entfernen der Führungsanordnung (18).

13. Verfahren nach Anspruch 12, wobei vor der Einstellung der Feldhomogenität in Schritt (e) hilfsweise eine äußere Brücke (20) an der Gehäusevorrichtung (9) angebracht wird und anschließend die Deckelbaugruppe (13) von der Gehäusevorrichtung (9) gelöst wird, wodurch die Deckelbaugruppen (13) verschiebbar und verdrehbar gegenüber der mittleren Magnetringbaugruppe (15) gelagert werden.

14. Verfahren nach Anspruch 12 oder 13, wobei nach dem Einstellen der Feldhomogenität in Schritt (e) Abstandshalter eingebracht werden, wo Spalten zwischen den Magnetringen (2) belassen werden sollen.

15. Verfahren zur Homogenisierung des Magnetfelds einer Magnetanordnung (1) nach einem der Ansprüche 1 bis 11, umfassend folgende Schritte:
Justieren der Magnetringe (2) als ganze, starre Baugruppen (13,15);
Verbessern die Homogenität des Magnetfelds im Messvolumen (0) durch laterale Verschiebung der Ringe (2) und/oder Verkippung gegenüber der z-Achse und/oder Verdrehen um die z-Achse.

## Claims

1. A magnet arrangement (1) for use in a magnetic resonance apparatus, having a permanent magnet system for generating a homogeneous magnetic field in a direction perpendicular to a z axis in a measurement volume (0), the permanent magnet system comprising at least two, in particular at least three, ring-shaped magnet elements (2) made of magnetic material, which are arranged cylindrically symmetrically with respect to the z axis and stacked on one another in the z direction and/or concentrically, the ring-shaped magnet elements (2) being made up of individual magnet segments (3) and arranged in such a way that the magnetization directions of the individual segments in the respective rings extend essentially parallel to a plane that is perpendicular to the z direction and parallel to a x-y plane, the ring-shaped magnet elements (2) respectively having a Halbach magnetization that generates a magnetic dipole field, and the ring-shaped magnet elements (2) being alignable relative to one another in the z direction,
**characterized in that**
before final mounting in the magnetic resonance apparatus, the ring-shaped magnet elements (2) are already prefabricated in a fixed fashion and their respective magnet segments (3) are fixed undisplaceably relative to one another,
that the ring-shaped magnet elements (2) are arranged in such a manner that they can be displaced relative to one another in parallel with the x-y plane,
and that the ring-shaped magnet elements (2) are mounted rotatably and/or tiltably relative to one another.

2. The magnet arrangement as claimed in claim 1, **characterized in that** the ring-shaped magnet elements (2) are mounted rotatably about the z axis.

3. The magnet arrangement as claimed in one of the preceding claims, **characterized in that** the ring-shaped magnet elements (2) are arranged concentrically about the z axis, and that radially outer ring-shaped magnet elements (5) are mounted in a fixed fashion, and radially inner ring-shaped magnet elements (4) are mounted in a mobile fashion, or vice versa.

4. The magnet arrangement as claimed in one of the preceding claims, **characterized in that** the ring-shaped magnet elements (2) are arranged concentrically about the z axis, and that a radially inner ring-shaped magnet element (4) has a higher coercive field strength than radially outer ring-shaped magnet elements (5).

5. The magnet arrangement as claimed in one of the preceding claims, **characterized in that** the ring-shaped magnet elements (2) are arranged stacked on one another in the z direction, that the permanent magnet system comprises at least three ring-shaped magnet elements (2), and that the central ring-shaped magnet element (8) as a whole is adhesively bonded in a fixed fashion and as a whole is displaceable laterally relative to the upper and lower ring-shaped magnet elements.

6. The magnet arrangement as claimed in one of the preceding claims, **characterized in that** the ring-shaped magnet elements (2) are arranged stacked on one another in the z direction, and that a central ring-shaped magnet element (8) is mobile only in the x-y plane and upper and lower ring-shaped magnet elements are displaceable and rotatable in the z direction.

7. The magnet arrangement as claimed in one of the preceding claims, **characterized in that** correction elements (10) for homogenizing the magnetic field are provided, for instance shim structures for shimming the higher field orders, preferably a shim tube.

8. The magnet arrangement as claimed in one of the preceding claims, **characterized in that** the ring-shaped magnet elements (2) are arranged stacked on one another in the z direction, and that a central ring-shaped magnet element (8) is made up of two concentric magnet rings (4,5), which are fastened with respect to one another, preferably by means of struts (6), in such a way that holes (7) for insertion of correction elements (10) for homogenizing the magnetic field remain between the rings.

9. The magnet arrangement as claimed in one of the preceding claims, **characterized in that** the ring-shaped magnet elements (2) are arranged stacked on one another in the z direction, and that a central ring-shaped magnet element (8) is mounted floating in the x-y plane, holding devices (11), in particular sliding blocks, being provided, which protrude through openings (12) in a housing device (9), which is part of the magnet arrangement (1), and with which the X-Y position of the central ring-shaped magnet element (8) can be adjusted.

10. The magnet arrangement as claimed in one of the preceding claims, **characterized in that** the permanent magnet system is bounded on both sides in the direction of the z axis by two cover modules (13), each of which comprises a ring-shaped magnet element and a cover component (14) with which the ring-shaped magnet elements (2) can be rotated on a housing device (9), can be displaced in the z direction and can be fastened on the housing device (9).

11. The magnet arrangement as claimed in claim 10, **characterized in that** positioning means (16), in particular adjustment screws, are provided, with which the cover modules (13) can be tilted out of the x-y plane and/or can be rotated about the z axis, relative to the housing device (9).

12. A method for producing a magnet arrangement (1) as claimed in one of claims 10 or 11, comprising the following steps:
(a) adhesively bonding the premagnetized magnet segments (3) to form magnet rings (2), preferably inside a holding ring (17);
(b) producing a central magnet ring module (15) by introducing a magnet ring (2) into a central ring-shaped housing device (9) having at least two openings (12), and fastening the magnet ring (2) by holding devices (11), which are mounted on the magnet ring (2) through the openings (12) in the housing device (9), so that the magnet ring (2) is mounted in a floating fashion in the housing device (9);
(c) fitting a guide arrangement (18) on the central magnet ring module (15) and on the cover modules (13), and joining together the magnet rings (2) against the repulsion forces of the magnets;
(d) fixing the cover components (14) on the housing device (9);
(e) iteratively measuring the field homogeneity and adjusting the position of the magnet rings (2) with respect to one another with the aid of positioning means (16);
(f) removing the guide arrangement (18).

13. The method as claimed in claim 12, wherein, before the adjustment of the field homogeneity in step (e), as an alternative an outer bridge (20) is fitted on the housing device (9) and the cover module (13) is subsequently separated from the housing device (9), so that the cover modules (13) are mounted displaceably and rotatably relative to the central magnet ring module (15).

14. The method as claimed in claim 12 or 13, wherein, after the adjustment of the field homogeneity in step (e), spacers are introduced where gaps are intended to be left between the magnet rings (2).

15. A method for homogenizing the magnetic field of a magnet arrangement (1) as claimed in one of claims 1 to 11, comprising the following steps:
adjusting the magnet rings (2) as entire rigid modules (13,15);
improving the homogeneity of the magnetic field in the measurement volume (0) by lateral displacement of the rings (2) and/or tilting relative to the z axis and/or rotation about the z axis.

## Revendications

1. Agencement d'aimants (1) destiné à être utilisé dans un appareil de résonance magnétique avec un système d'aimants permanents pour générer un champ magnétique homogène dans une direction perpendiculaire à un axe z dans un volume de mesure (0), dans lequel le système d'aimants permanents comprend au moins deux, en particulier au moins trois éléments magnétiques annulaires (2) en matériau magnétique disposés de manière cylindrosymétrique par rapport à l'axe z et empilés et/ou disposés concentriquement les uns au-dessus des autres dans la direction z, dans lequel les éléments magnétiques annulaires (2) sont constitués de segments magnétiques individuels (3) et disposés de telle sorte que la direction de magnétisation des segments individuels dans les anneaux respectifs est sensiblement parallèle à un plan parallèle à un plan x-y perpendiculaire à la direction z, dans lequel les éléments magnétiques annulaires (2) présentent chacun une magnétisation de Halbach qui génère un champ magnétique dipolaire, et dans lequel les éléments magnétiques annulaires (2) peuvent être orientés les uns par rapport aux autres dans la direction z,
**caractérisé en ce**
**que** les éléments magnétiques annulaires (2) sont préfabriqués de manière fixe avant le montage final dans l'appareil de résonance magnétique, et leurs segments magnétiques respectifs (3) sont fixés de manière à ne pas pouvoir être déplacés les uns par rapport aux autres,
**que** les éléments magnétiques annulaires (2) sont montés de manière à pouvoir être déplacés les uns par rapport aux autres parallèlement au plan x-y et
**que** les éléments magnétiques annulaires (2) sont montés de manière à pouvoir être tournés et/ou inclinés les uns par rapport aux autres.

2. Agencement d'aimants selon la revendication 1, **caractérisé en ce que** les éléments magnétiques annulaires (2) sont montés de manière à pouvoir être tournés autour de l'axe z.

3. Agencement d'aimants selon l'une des revendications précédentes, **caractérisé en ce que** les éléments magnétiques annulaires (2) sont disposés concentriquement autour de l'axe z, et que des éléments magnétiques annulaires radialement extérieurs (5) sont montés de manière fixe, des éléments magnétiques annulaires radialement intérieurs (4) de manière mobile ou inversement.

4. Agencement d'aimants selon l'une des revendications précédentes, **caractérisé en ce que** les éléments magnétiques annulaires (2) sont disposés concentriquement autour de l'axe z, et qu'un élément magnétique annulaire radialement intérieur (4) présente une intensité de champ coercitif plus élevée que des éléments magnétiques annulaires radialement extérieurs (5).

5. Agencement d'aimants selon l'une des revendications précédentes, **caractérisé en ce que** les éléments magnétiques annulaires (2) sont empilés les uns au-dessus des autres dans la direction z, que le système d'aimants permanents présente au moins trois éléments magnétiques annulaires (2), et que l'élément magnétique annulaire central (8) est solidement collé comme un tout et peut être déplacé latéralement comme un tout contre les éléments magnétiques annulaires supérieur et inférieur.

6. Agencement d'aimants selon l'une des revendications précédentes, **caractérisé en ce que** les éléments magnétiques annulaires (2) sont empilés les uns au-dessus des autres dans la direction z, et qu'un élément magnétique annulaire central (8) est mobile seulement dans le plan x-y et des éléments magnétiques annulaires supérieur et inférieur peuvent être déplacés et tournés dans la direction z.

7. Agencement d'aimants selon l'une des revendications précédentes, **caractérisé en ce que** des éléments de correction (10) pour homogénéiser le champ magnétique, tels que des structures de compensation (en anglais : shim) pour compenser les ordres de champ supérieurs, de préférence un tube de compensation, sont présents.

8. Agencement d'aimants selon l'une des revendications précédentes, **caractérisé en ce que** les éléments magnétiques annulaires (2) sont empilés les uns au-dessus des autres dans la direction z, et qu'un élément magnétique annulaire central (8) est constitué de deux anneaux magnétiques concentriques (4, 5) qui sont fixés l'un à l'autre, de préférence au moyen de branches (6), de telle sorte qu'il reste entre les anneaux des évidements (7) pour l'introduction d'éléments de correction (10) destinés à homogénéiser le champ magnétique.

9. Agencement d'aimants selon l'une des revendications précédentes, **caractérisé en ce que** les éléments magnétiques annulaires (2) sont empilés les uns au-dessus des autres dans la direction z, et qu'un élément magnétique annulaire central (8) est monté flottant dans le plan x-y, des dispositifs de maintien (11), en particulier des coulisseaux, étant prévus, qui font saillie à travers des ouvertures (12) dans un dispositif de logement (9) qui fait partie de l'agencement d'aimants (1) et avec lequel la position X-Y de l'élément magnétique annulaire central (8) peut être réglée.

10. Agencement d'aimant selon l'une des revendications précédentes, **caractérisé en ce que** le système d'aimants permanents est limité des deux côtés dans la direction de l'axe z par deux ensembles couvercle (13), qui comprennent chacun un élément magnétique annulaire et un élément formant couvercle (14), avec lequel les éléments magnétiques annulaires (2) peuvent être tournés sur un dispositif de logement (9) et déplacés dans la direction z ainsi que fixés sur le dispositif de logement (9).

11. Agencement d'aimants selon la revendication 10, **caractérisé en ce que** des moyens de positionnement (16), en particulier des vis de réglage, sont prévus, avec lesquels les ensembles couvercle (13) peuvent être inclinés hors du plan x-y et/ou tournés autour de l'axe z par rapport au dispositif de logement (9).

12. Procédé de fabrication d'un agencement d'aimants (1) selon l'une des revendications 10 ou 11, comprenant les étapes suivantes :
(a) collage des segments magnétiques prémagnétisés (3) pour former des anneaux magnétiques (2), de préférence à l'intérieur d'un anneau de maintien (17) ;
(b) réalisation d'un ensemble anneau magnétique central (15) par insertion d'un anneau magnétique (2) dans un dispositif de logement annulaire central (9) présentant au moins deux ouvertures (12) et fixation de l'anneau magnétique (2) au moyen de dispositifs de maintien (11) qui sont montés sur l'anneau magnétique (2) à travers les ouvertures (12) dans le dispositif de logement (9), de telle sorte que l'anneau magnétique (2) soit monté flottant dans le dispositif de logement (9) ;
c) mise en place d'un agencement de guidage (18) sur l'ensemble anneau magnétique central (15) ainsi que sur les ensembles couvercle (13) et assemblage des anneaux magnétiques (2) à l'encontre des forces de répulsion des aimants ;
d) fixation des éléments formant couvercle (14) au dispositif de logement (9) ;
e) mesure itérative de l'homogénéité de champ et réglage de la position des anneaux magnétiques (2) les uns par rapport aux autres à l'aide de moyens de positionnement (16) ;
f) enlèvement de l'agencement de guidage (18).

13. Procédé selon la revendication 12, dans lequel, avant le réglage de l'homogénéité de champ à l'étape (e), un pont extérieur (20) est mis en place à titre auxiliaire sur le dispositif de logement (9) et l'ensemble couvercle (13) est ensuite détaché du dispositif de logement (9), les ensembles couvercle (13) étant ainsi montés de manière à pouvoir être déplacés et tournés par rapport à l'ensemble anneau magnétique central (15).

14. Procédé selon la revendication 12 ou 13, dans lequel, après avoir réglé l'homogénéité de champ à l'étape (e), des entretoises sont mises en place aux endroits où des espaces doivent être laissés entre les anneaux magnétiques (2).

15. Procédé pour homogénéiser le champ magnétique d'un agencement d'aimants (1) selon l'une des revendications 1 à 11, comprenant les étapes suivantes :
réglage des anneaux magnétiques (2) en tant qu'ensembles rigides complets (13, 15) ;
amélioration de l'homogénéité du champ magnétique dans le volume de mesure (0) par déplacement latéral des anneaux (2) et/ou inclinaison par rapport à l'axe z et/ou rotation autour de l'axe z.
